# EUROPEAN PATENT APPLICATION

(11) **EP 4 286 829 A1**
(43) Date of publication of application: **06.12.2023**
(21) Application number: 23172231.5
(22) Date of filing: 09.05.2023
(51) Int. Cl.: G01N 17/00, G05B 23/00, G01R 33/00

(54) **DETECTION DEVICE, ANALYSIS METHOD, ANALYSIS COMPUTER PROGRAM, AND NON-TRANSITORY COMPUTER-READABLE RECORDING MEDIUM FOR CORROSION MONITORING OF PIPES**

(30) Priority: 30.05.2022 JP 2022087714
(71) Applicant: Yokogawa Electric Corporation, Musashino-shi, Tokyo 180-8750 (JP)
(72) Inventor: MITO, Shinya, Musashino-shi (JP); MIYAZAWA, Kazunori, Musashino-shi (JP); MIHARA, Eiji, Musashino-shi (JP)
(74) Representative: Osha BWB

(57) **Abstract**

A detection device (100) includes a processor (2e) configured to detect a state change of a target object (50) based on sensor value array data (7-1) in which sensor values (SV) acquired from sensors (1) are associated with array positions of the sensors (1), generate, with respect to two pieces of the sensor value array data (7-1, 7-2) for which the sensor values (SV) are acquired at different times, differential value array data (8-1), generate, from the differential value array data (8-1), two pieces of partial differential value array data (9-1, 9-2), and determine presence or absence of a smooth change of the differential values (ΔSV) in the differential value array data (8-1) based on a result of threshold determination on similarity between the differential values (ΔSV) in the two pieces of partial differential value array data (9-1, 9-2) and a result of threshold determination on a variance value of the differential value array data (8-1).

## Description

### BACKGROUND OF THE INVENTION

### Technical Field

The present invention relates to a detection device, an analysis method, an analysis computer program, and a non-transitory computer readable recording medium.

### Description of the Related Art

Sensor values of a plurality of sensors that are arranged in an array manner may be affected by a disturbance in some cases. To detect a disturbance, it may be possible to use pattern matching that is known in the field of image processing. For example, Japanese Laid-open Patent Publication No. 2016-81264 discloses a technology for preparing a characteristic portion of a detection target object as a pattern image, and determining whether the detection target object is included in a processing target image based on a similarity between the pattern image and the processing target image.

For example, in a localized corrosion monitoring device for a metal or the like, local changes among sensor values of a plurality of magnetic sensors are detected. To distinguish a disturbance, there is a need to detect a change between the sensor values that is caused by the disturbance. Not a few disturbances have smooth spatial distributions, and smooth changes appear among the plurality of sensor values due to the disturbances. There are countless change patterns, and therefore, it is difficult to prepare all of the patterns. In the pattern matching, it is difficult to detect smooth changes among the sensor values of the plurality of sensors.

### SUMMARY OF THE INVENTION

One or more embodiments provide a technological improvement over conventional technologies. In particular, a detection device, an analysis method, an analysis program, and a non-transitory computer readable recording medium according to one or more embodiments may be able to detect smooth changes among sensor values of a plurality of sensors.

This provides a practical, technological improvement over conventional technologies that would be readily appreciated by those skilled in the art.

Further details regarding the various improvements and advantages will become apparent from the descriptions that follow.

A detection device according to one aspect of the present disclosure is defined in claim 1. A detection device according to one or more embodiments includes: an analysis unit that detects a state change of a target object based on sensor value array data in which sensor values that are acquired from a plurality of sensors that are arranged in an array manner with respect to the target object are associated with array positions of the plurality of sensors, wherein the analysis unit generates, with respect to two pieces of the sensor value array data for which the sensor values are acquired at different times, differential value array data in which differential values of the sensor values of the two pieces of the sensor value array data are associated with the array positions of the plurality of sensors, generates, from the differential value array data, two pieces of partial differential value array data each including same number of elements and including overlapping elements, and determines presence or absence of a smooth change of the differential values in the differential value array data based on a result of threshold determination on similarity between the differential values in the two pieces of partial differential value array data and a result of threshold determination on a variance value of the differential value array data.

An analysis method according to one aspect of the present disclosure is defined in claim 10. An analysis method according to one or more embodiments is a method for analyzing sensor value array data in which sensor values that are acquired from a plurality of sensors that are arranged in an array manner are associated with array positions of the plurality of sensors, the analysis method includes: generating, with respect to two pieces of the sensor value array data for which the sensor values are acquired at different times, differential value array data in which differential values of the sensor values of the two pieces of the sensor value array data are associated with the array positions of the plurality of sensors, generating, from the differential value array data, two pieces of partial differential value array data each including same number of elements and including overlapping elements, and determining presence or absence of a smooth change of the differential values in the differential value array data based on a result of threshold determination on similarity between the differential values in the two pieces of partial differential value array data and a result of threshold determination on a variance value of the differential value array data.

According to further aspects of the present disclosure, an analysis computer program and a non-transitory computer-readable recording medium are defined in claims 11 and 12, respectively. An analysis computer program according to one or more embodiments comprises instructions which, when the program is executed by a computer, cause the computer to carry out the analysis method as defined in any of the embodiments described herein. A non-transitory computer-readable recording medium according to one or more embodiments stores instructions that cause a computer to carry out the analysis method as defined in any of the embodiments described herein. A non-transitory computer-readable recording medium according to one or more embodiments is a medium on which an analysis computer program (instructions) for performing a process of analyzing sensor value array data in which sensor values that are acquired from a plurality of sensors that are arranged in an array manner are associated with array positions of the plurality of sensors is recorded, the program instructs a computer to execute: generating, with respect to two pieces of the sensor value array data for which the sensor values are acquired at different times, differential value array data in which differential values of the sensor values of the two pieces of the sensor value array data are associated with the array positions of the plurality of sensors, generating, from the differential value array data, two pieces of partial differential value array data each including same number of elements and including overlapping elements, and determining presence or absence of a smooth change of the differential values in the differential value array data based on a result of threshold determination on similarity between the differential values in the two pieces of partial differential value array data and a result of threshold determination on a variance value of the differential value array data.

### BRIEF DESCRIPTION OF THE DRAWINGS

FIG. 1 is a diagram illustrating an example of a schematic configuration of a detection device according to one or more embodiments;
FIG. 2 is a diagram illustrating an example of a schematic configuration of sensors included in the detection device;
FIG. 3 is a diagram illustrating an example of sensor value array data;
FIG. 4 is a diagram illustrating an example of differential value array data;
FIG. 5 is a diagram illustrating an example of partial differential value array data and partial differential value array data;
FIG. 6 is a diagram illustrating an example of a smooth change of differential values in the differential value array data;
FIG. 7 is a diagram schematically illustrating similarity between the partial differential value array data and the partial differential value array data that are generated from the differential value array data in FIG. 6;
FIG. 8 is a diagram illustrating an example of a local change of the differential values in the differential value array data;
FIG. 9 is a diagram schematically illustrating similarity between the partial differential value array data and the partial differential value array data that are generated from the differential value array data in FIG. 8;
FIG. 10 is a flowchart illustrating an example of a process (a detection method and an analysis method) performed by the detection device; and
FIG. 11 is a diagram illustrating an example of a hardware configuration of a detection unit.

### DETAILED DESCRIPTION OF PREFERRED EMBODIMENTS

Embodiments will be described below with reference to the drawings. The same components are denoted by the same reference symbols, and repeated explanation will be omitted appropriately.

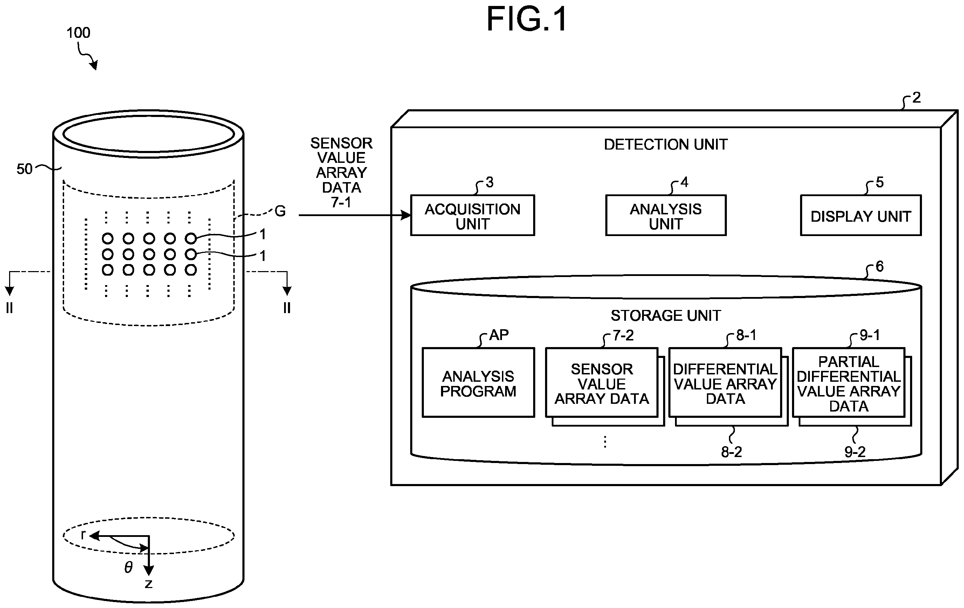

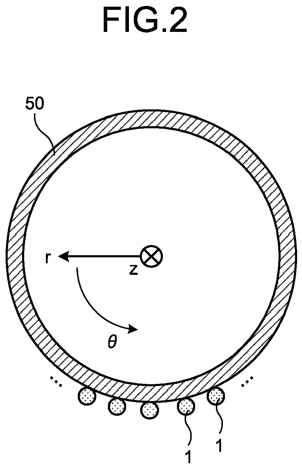

FIG. 1 is a diagram illustrating an example of a schematic configuration of a detection device 100 according to one or more embodiments. FIG. 2 is a diagram illustrating an example of a schematic configuration of sensors 1 included in the detection device 100, and schematically illustrates a cross-section taken along a line II in FIG. 1. The detection device 100 includes the plurality of sensors 1 and a detection unit 2. The plurality of sensors 1 and the detection unit 2 are configured in a communicable manner such that it becomes possible to transmit data from at least each of the sensors 1 to the detection unit 2. The communication may be wired communication or wireless communication.

The detection device 100 is used to detect a state change of a target object, for example. Examples of the target object includes a part of a pipe 50. The pipe 50 has a cylindrical shape and a corresponding cylindrical coordinate system is illustrated. A θ direction corresponds to a circumferential direction of the pipe 50. A z direction corresponds to an axial direction (extending direction) of the pipe 50. A r direction corresponds to a radial direction of the pipe 50.

The plurality of sensors 1 are arranged in an array manner with respect to the pipe 50. In this example, the plurality of sensors 1 are arranged in a two-dimensional array in the θ direction and the z direction along a side surface of the pipe 50. The plurality of sensors 1 are also referred to and illustrated as a sensor group G. The sensor group G functions as a measurement unit that measures a state of the pipe 50 by using the plurality of sensors 1.

An array position of each of the sensors 1 is identified with reference to a position of one of the sensors 1 in the sensor group G. In the following, the position of the sensor 1 located at an uppermost left (at a positive r direction side and a negative z direction side) is used as a reference. Assuming that an array number in a positive θ direction is represented by m and an array number in a positive z direction is represented by n, the array position of each of the sensors 1 is identified as (m, n). It is assumed that m is an integer from 0 to M, and n is an integer from 0 to N. In the positive θ direction, a certain number of the sensors 1, where the certain number is m = 0 to M (M+1), are arranged. In the positive z direction, a certain number of sensors 1, where the certain number is n = 0 to N (N+1), are arranged.

Detected values (measured values or the like) of the sensors 1 will be referred to as sensor values SV. The sensor value SV of each of the sensors 1 is transmitted to the detection unit 2.

The detection unit 2 detects a state change of the pipe 50. In one or more embodiments, the pipe 50 may be a metal pipe. The sensors 1 may be magnetic sensors, and the sensor values SV may be values indicating directions, magnitudes, or the like of magnetic fields that are generated around the pipe 50. The detection unit 2 may detect occurrence of localized corrosion of the pipe 50. In other words, as one example, the detection device 100 including the detection unit 2 functions as a localized corrosion detection (or monitoring) device. In the following, it is assumed that the detection unit 2 detects occurrence of localized corrosion of the pipe 50 unless otherwise specified.

Meanwhile, the plurality of sensors 1 among the plurality of sensors 1 and the detection unit 2 may be components of the detection device 100, or need not always be components of the detection device 100. The detection unit 2 may be a computer or the like that is installed in the vicinity of the plurality of sensors 1, or a computer, a higher-level device, or the like that is remotely installed from the sensors 1 via a network (not illustrated), for example. The detection device 100 may be a device that integrally include the plurality of sensors 1 and the detection unit 2, for example.

FIG. 1 also illustrates functional blocks of the detection unit 2. The detection unit 2 includes an acquisition unit 3, an analysis unit 4, a display unit 5, and a storage unit 6.

The storage unit 6 will be described first. Examples of information that is stored in the storage unit 6 include an analysis program AP (instructions), a plurality of pieces of sensor value array data 7, a plurality of pieces of differential value array data 8, and a plurality of pieces of partial differential value array data 9. For the sake of convenience, the plurality of pieces of sensor value array data 7 will be referred to and illustrated as sensor value array data 7-1, sensor value array data 7-2, and the like. Meanwhile, in the example illustrated in FIG. 1, the sensor value array data 7-1 is not yet stored in the storage unit 6. The plurality of pieces of differential value array data 8 will be referred to and illustrated as differential value array data 8-1, differential value array data 8-2, and the like. The plurality of pieces of partial differential value array data 9 will be referred to and illustrated as partial differential value array data 9-1 and partial differential value array data 9-2. The analysis program AP is a program (software) that causes a computer to function as the detection unit 2. The sensor value array data 7, the differential value array data 8, and the partial differential value array data 9 will be described in detail later.

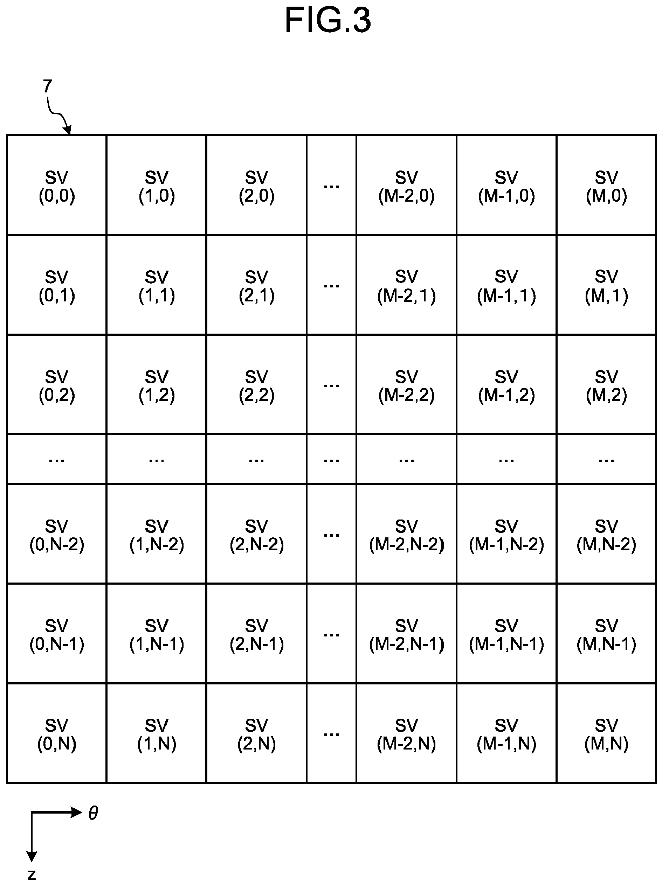

The acquisition unit 3 acquires the sensor values SV of the plurality of sensors 1. The plurality of sensors value SV that are acquired by the acquisition unit 3 are handled as the sensor value array data 7. The sensor value array data 7 will be described below with reference to FIG. 3.

FIG. 3 is a diagram illustrating an example of the sensor value array data 7. The sensor value array data 7 is data in which the sensor values SV of the plurality of sensors 1 are associated with the array positions of the plurality of sensors 1. The single sensor value SV corresponds to a single element in the sensor value array data 7. The single element in this example is configured (or identified) by the sensor value SV and the array position of the sensor 1 that is associated with the sensor value SV. A certain number of the sensor vales SV, where the certain number is m = 0 to M (M+1), are arrayed in the θ direction. A certain number of sensor values SV, where the certain number is n = 0 to N (N+1), are arrayed in the z direction. The number of the elements in the sensor value array data 7 is (M+1) × (N+1).

Referring back to FIG. 1, the acquisition unit 3 acquires the sensor value array data 7 repeatedly at a predetermined cycle or at an arbitrary timing corresponding to user operation or the like. Examples of the predetermined cycle include several hours, several days, and several weeks. The sensor value array data 7 that is acquired by the acquisition unit 3 is stored in the storage unit 6. By repetition of the operation as described above, the plurality of pieces of sensor value array data 7, which have the plurality of different sensor values SV that are acquired at different times, are stored in the storage unit 6.

The sensor value array data 7-1 between the sensor value array data 7-1 and the sensor value array data 7-2 illustrated in FIG. 1 is the sensor value array data 7 that is currently acquired by the acquisition unit 3. The sensor value array data 7-2 is the sensor value array data 7 that is previously acquired by the acquisition unit 3. An acquisition time of the sensor value array data 7-1 is later than an acquisition time of the sensor value array data 7-2. In the state illustrated in FIG. 1, the sensor value array data 7-1 is not yet stored in the storage unit 6, and the sensor value array data 7-2 and the like that are previously acquired are stored in the storage unit 6.

The analysis unit 4 analyzes the sensor value array data 7-1 to detect a state change of the pipe 50, that is, occurrence or non-occurrence of localized corrosion. This will be described in detail below.

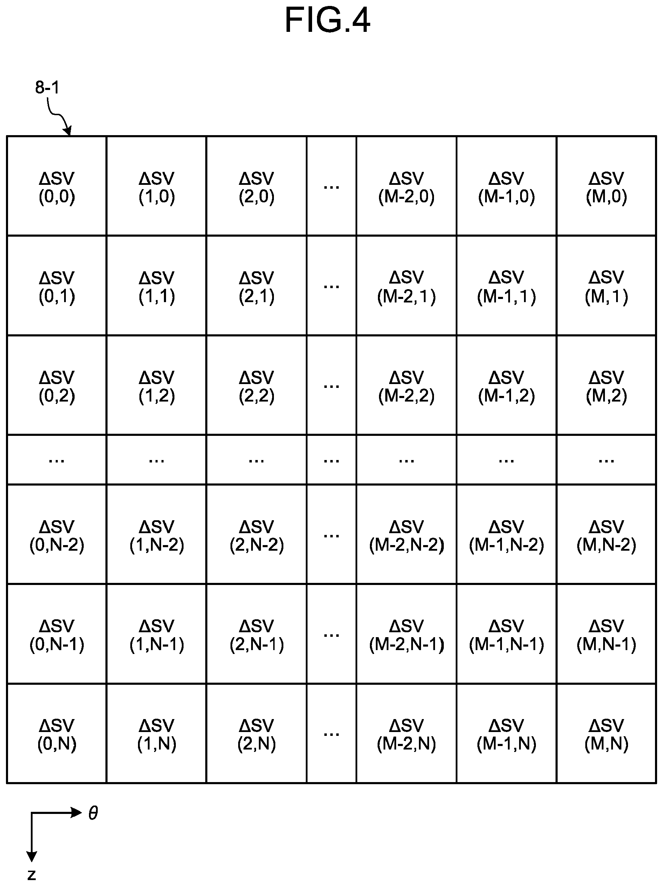

The analysis unit 4 calculates a difference between the sensor value array data 7-1 and the sensor value array data 7-2 and generates the differential value array data 8-1. The differential value array data 8-1 will be described below with reference to FIG. 4.

FIG. 4 is a diagram illustrating an example of the differential value array data 8-1. The differential value array data 8-1 is data in which differential values ΔSV between the sensor values SV of the sensor value array data 7-1 and the sensor value array data 7-2 are associated with the array positions of the plurality of sensors 1. The differential values ΔSV (m, n) are differential values of the sensor values SV (m, n) of the sensor value array data 7-1 with respect to the sensor values SV (m, n) of the sensor value array data 7-2. The single differential value ΔSV corresponds to a single element in the differential value array data 8-1. In this example, the single element is configured by the differential value ΔSV and the array position of the sensor 1 associated with the differential value ΔSV. A certain number of the differential values ΔSV, where the certain number is m = 0 to M (M+1), are arrayed in the θ direction. A certain number of the differential values ΔSV, where the certain number is n = 0 to N (N+1), are arrayed in the z direction. The number of elements in the differential value array data 8-1 is (M+1) × (N+1).

Referring back to FIG. 1, due to temporal deterioration of the pipe 50 or the like, localized corrosion occurs in the pipe 50. The local in this example indicates an area that is narrower than an area of the sensor group G in which the plurality of sensors 1 are arranged, such as an area that is smaller than a half of the area of the sensor group G. If the localized corrosion occurs in the pipe 50, the sensor value SV of the sensor 1 that is arranged at a corresponding position changes. The change appears as a local difference between the sensor values SV of the sensor value array data 7-1 and the sensor value array data 7-2, that is, a local change at the array position of the sensor 1 associated with the differential value ΔSV in the differential value array data 8-1. By detecting the local change at the array position of the sensor 1 associated with the differential value ΔSV in the differential value array data 8-1, where the local change occurs due to the localized corrosion of the pipe 50, it is possible to detect occurrence of the localized corrosion of the pipe 50.

In contrast, the sensor values SV of the plurality of sensors 1 may be affected by a disturbance. Examples of a factor of the disturbance include presence of a magnet, and a magnet is often present in a place except for the vicinity of the sensor group G. Due to the disturbance as described above, a magnetic field with a smooth spatial distribution is generated in the sensor group G. Along with the distribution, the sensor value SV of each of the sensors 1 changes. In other words, a smooth change occurs among the sensor values SV of the plurality of sensors 1. The change appears as a smooth change between the sensor values SV of the sensor value array data 7-1 and the sensor value array data 7-2, that is, a smooth change of the differential values ΔSV in the differential value array data 8-1. The change off the differential values ΔSV with the smooth change of the spatial distribution is a moderate change as compared to the local change of the differential values ΔSV as described above, and indicates a moderate change that occurs over a half or more of the area of the sensor group G or over a majority of the area of the sensor group G, for example. Meanwhile, in the case of disturbance in which a magnetic field that is distributed along the side surface (curved surface) of the pipe 50 is generated, a smooth change of the differential values ΔSV does not appear in some cases, but an exceptional disturbance as described above is not taken into account in this example.

To distinguish a disturbance, there is a need to detect the disturbance. In other words, there is a need to detect a smooth change between the sensor values SV of the plurality of sensors 1, in particular, a smooth change of the differential values ΔSV in the differential value array data 8-1. As described above, it is difficult to address this by pattern matching as described in Japanese Laid-open Patent Publication No. 2016-81264.

It may be possible to adopt a method using a statistical value, such as an average value or a variance value. In other words, if magnetic fields in the same direction are generated in the sensor group G due to a disturbance, an average value of the plurality of differential values ΔSV in the differential value array data 8-1 changes. It may be possible to detect a disturbance by threshold determination with respect to the average value. Furthermore, if magnetic fields in various directions is generated in the sensor group G due to a disturbance, a variance value changes. It may be possible to detect a disturbance by threshold determination with respect to the variance value.

However, only with use of the statistical values as described above, it is difficult to distinguish between the local change and the smooth change of the differential values ΔSV in the differential value array data 8-1, so that it is difficult to detect a disturbance. Each of the differential values ΔSV in the differential value array data 8-1 may be a positive value and a negative value, so that the average value may be any value including zero. It is difficult to detect the smooth change of the differential values ΔSV in the differential value array data 8-1. The variance value has an increasing tendency, and the local change of the differential values ΔSV in the differential value array data 8-1 has the same tendency, so that it is difficult to distinguish between the local change and the smooth change.

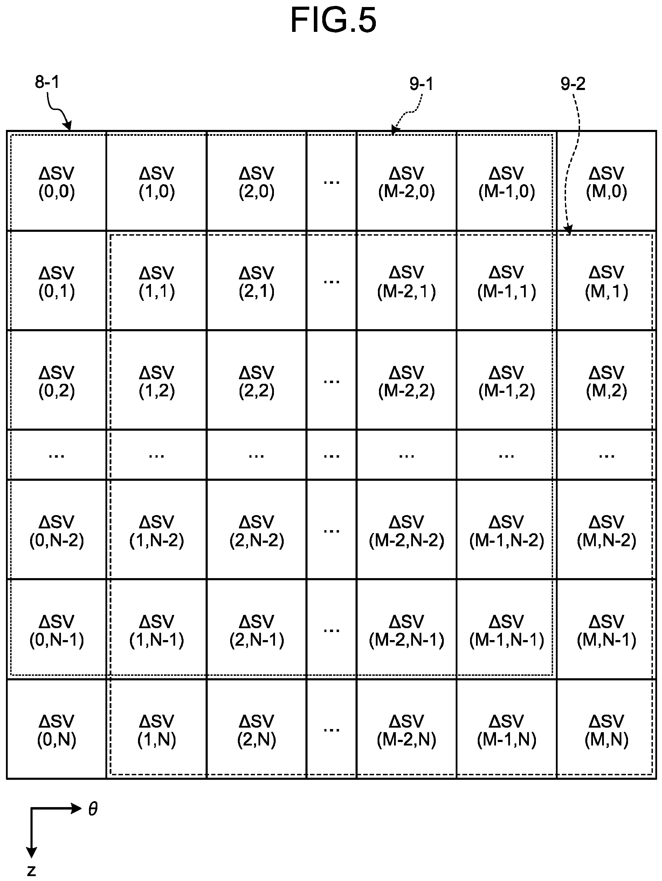

To cope with this, in one or more embodiments, the analysis unit 4 first detects a disturbance by a method as described below. First, the analysis unit 4 generates the two pieces of partial differential value array data 9, each including the same number of elements and including some overlapping elements, from the differential value array data 8-1. The overlapping elements in this example indicate the same elements in the differential value array data 8-1 from which the pieces of data are generated. The first partial differential value array data 9 between the two pieces of partial differential value array data 9 is the partial differential value array data 9-1. The second partial differential value array data 9 is the partial differential value array data 9-2. This will be described below with reference to FIG. 5.

FIG. 5 is a diagram illustrating an example of the partial differential value array data 9-1 and the partial differential value array data 9-2. The partial differential value array data 9-1 includes elements in a first range of the differential value array data 8-1. The partial differential value array data 9-2 includes elements in a second range of the differential value array data 8-1. The second range is deviated from the first range by a predetermined number of elements in the array directions of the differential value array data 8-1, in particular, the array directions of the array positions of the plurality of sensors 1 associated with the differential value SV. The predetermined number may be determined as an arbitrary number in a range in which the smooth change and the local change of the differential values ΔSV in the differential value array data 8-1 are distinguishable. The θ direction and the z direction are present as the array directions, and the predetermined number in the θ direction and the predetermined number in the z direction may be the same or different.

In the example illustrated in FIG. 5, the predetermined number is one in both of the θ direction and the z direction. The first range in the differential value array data 8-1 is a range of m = 0 to (M-1) and n = 0 to (N-1). In the θ direction, a certain number of the differential values ΔSV, where the certain number is m = 0 to (M-1) (M), are arrayed. In the z direction, a certain number of the differential values ΔSV, where the certain number is n = 0 to (N-1) (N), are arrayed. The number of elements in the partial differential value array data 9-1 is (M×N).

The second range of the differential value array data 8-1 is a range of m = 1 to M and n = 1 to N. In the θ direction, a certain number of the differential values ΔSV, where the certain number is m = 1 to M (M), are arrayed. In the z direction, a certain number of the differential values ΔSV, where the certain number is n= 1 to N (N), are arrayed. The number of elements in the partial differential value array data 9-2 is (M×N).

The analysis unit 4 calculates similarity between the differential values ΔSV of the partial differential value array data 9-1 and the partial differential value array data 9-2. Examples of the similarity include a correlation coefficient. In calculation of the similarity, it is assumed that the element (m, n) in the partial differential value array data 9-1 and the element (m+1, n+1) in the partial differential value array data 9-2 correspond to each other.

### First determination

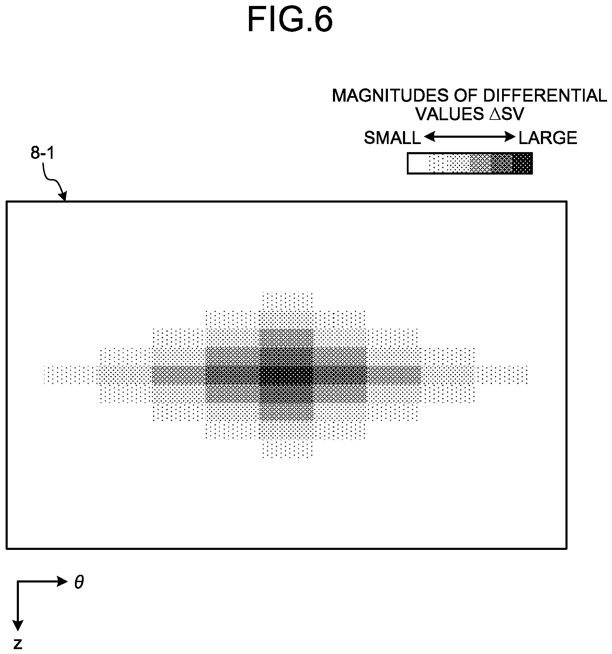

The analysis unit 4 performs threshold determination (first determination) with respect to the similarity. For example, the analysis unit 4 determines whether the similarity is equal to or larger than a threshold or smaller than the threshold. Here, the similarity that is calculated when the smooth change of the differential values ΔSV is present in the differential value array data 8-1 is larger than the similarity that is calculated when only the local change is present. This will be described below with reference to FIG. 6 to FIG. 9.

FIG. 6 is a diagram illustrating an example of the smooth change of the differential values ΔSV in the differential value array data 8-1. A distribution of magnitudes of the differential values ΔSV is schematically illustrated by hatching. It is indicated that spatial distributions of a range in which the magnitudes of the differential values ΔSV change from small to large and a range in which the magnitudes of the differential values ΔSV change from large to small are wide and smooth.

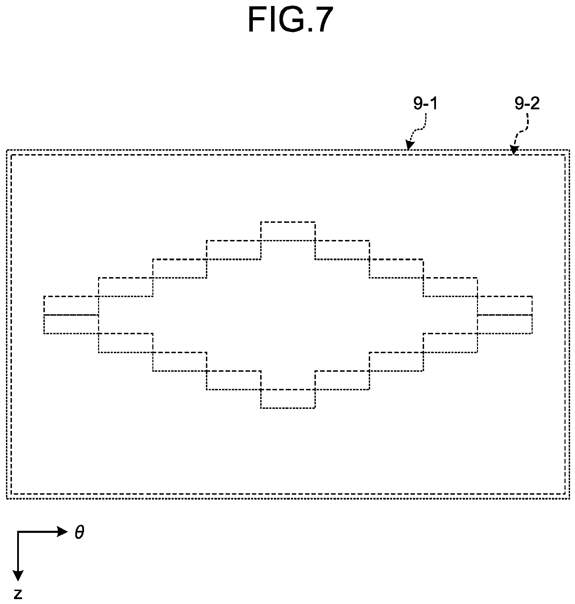

FIG. 7 is a diagram schematically illustrating similarity between the partial differential value array data 9-1 and the partial differential value array data 9-2 that are generated from the differential value array data 8-1 illustrated in FIG. 6. Only a contour of the hatching portion in FIG. 6 is indicated by a dashed line, and the partial differential value array data 9-1 and the partial differential value array data 9-2 are illustrated in an overlapping manner. As can be understood from the drawing, in the overlapping portion of the partial differential value array data 9-1 and the partial differential value array data 9-2, there are many portions in which the differential values ΔSV change in the same tendency. Therefore, the similarity between the differential values ΔSV of the partial differential value array data 9-1 and the partial differential value array data 9-2 increases.

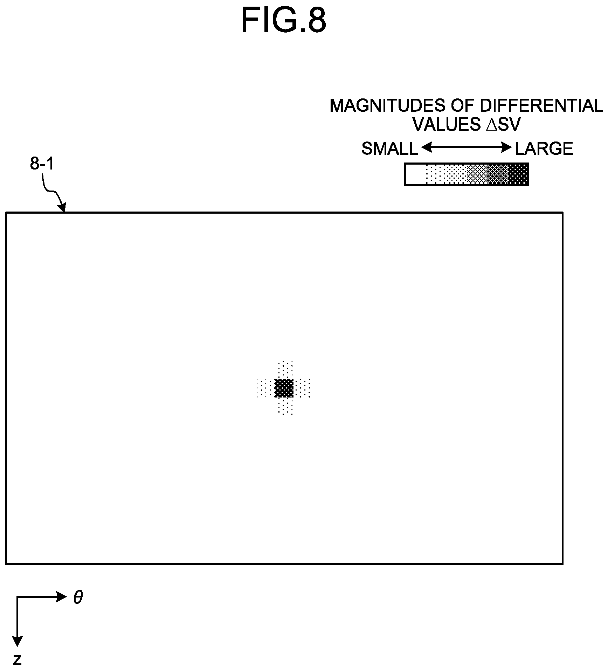

FIG. 8 is a diagram illustrating an example of the local change of the differential values ΔSV in the differential value array data 8-1. The differential values ΔSV change in a local range that is narrower than the range illustrated in FIG. 6 as described above.

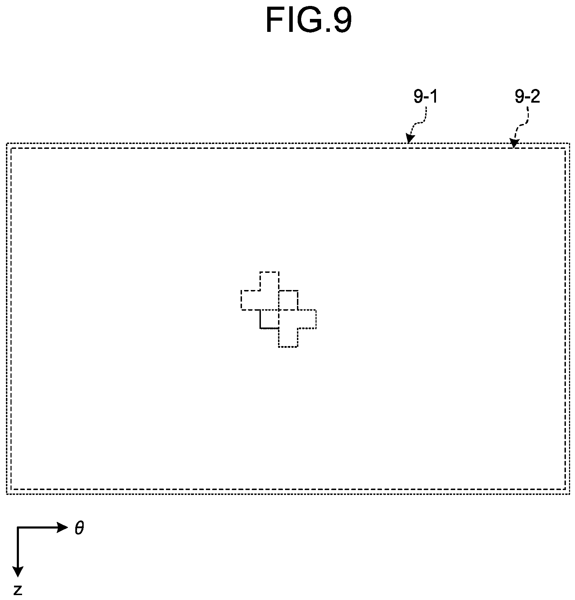

FIG. 9 is a diagram schematically illustrating similarity between the partial differential value array data 9-1 and the partial differential value array data 9-2 that are generated from the differential value array data 8-1 illustrated in FIG. 8. Only a contour of the hatching portion in FIG. 8 is indicated by a dashed line, and the partial differential value array data 9-1 and the partial differential value array data 9-2 are illustrated in an overlapping manner. As can be understood from the drawing, in the overlapping portion of the partial differential value array data 9-1 and the partial differential value array data 9-2, there are few portions in which the differential values ΔSV change in the same tendency. Therefore, the similarity between the differential values ΔSV of the partial differential value array data 9-1 and the partial differential value array data 9-2 decreases.

The threshold with respect to the similarity is set so as to be able to distinguish the smooth change of the differential values ΔSV in the differential value array data 8-1 as illustrated in FIG. 6 and FIG. 7 as described above and the local change of the differential values ΔSV in the differential value array data 8-1 as illustrated in FIG. 8 and FIG. 9 as described above, for example. Furthermore, the threshold is set by taking into account white noise of the sensor 1 that is used in an actual environment, noise that is generated from a peripheral device or the like, and a temperature correction error due to a change in environmental temperature.

### Second determination

Referring back to FIG. 1, the analysis unit 4 performs threshold determination (second determination) with respect to the variance value of the differential value array data 8-1 in addition to the first determination. Specifically, the analysis unit 4 adopts the plurality of differential values ΔSV that are elements of the differential value array data 8-1 as a population, and calculates a variance value of the population. The analysis unit 4 performs threshold determination with respect to the calculated variance value. For example, the analysis unit 4 determines whether the variance value is equal to or larger than a threshold or smaller than the threshold.

### Third determination

The analysis unit 4 determines (third determination) presence or absence of the smooth change of the differential values ΔSV in the differential value array data 8-1 based on a result of the first determination and a result of the second determination as described above. Specifically, if the similarity is equal to or larger than the threshold in the first determination and the variance value is equal to or larger than the threshold in the second determination, the analysis unit 4 determines that the smooth change of the differential values ΔSV is present in the differential value array data 8-1, that is, a disturbance is present, and in other cases, the analysis unit 4 determines that the smooth change of the differential values ΔSV is not present in the differential value array data 8-1. In this manner, it is possible to detect the smooth change between the sensor values SV that are acquired at different times in the plurality of sensors 1, that is, a disturbance.

The reason that a disturbance is detectable by the first to the third determination as described above will be described below based on classification of the differential value array data 8-1 that is a basis of the determination into three categories.
Category 1: the differential value array data 8-1 includes only random noise.
Category 2: the differential value array data 8-1 includes random noise and some elements having larger values than random noise.
Category 3: the differential value array data 8-1 includes random noise and all of elements have certain values by which random noise is smoothed.

Furthermore, with respect to the categories 1 to 3 as described above, for example, behaviors of the similarity in the first determination and the variance value in the second determination in each of a case where the random noise included in the differential value array data 8-1 is equal to an expected value that is expected from an actual environment, a peripheral device, or the environmental temperature, a case where the random noise is smaller than the expected value, and a case where the random noise is larger than the expected value will be illustrated in Table 1 below. This is because when the sensors 1 are used in the actual environment, the threshold for the determination is determined by taking into account white noise of the sensors 1, noise generated by a peripheral device or the like, and a temperature correction error due to a change in the environmental temperature, so that there may be a case in which the random noise is smaller than expected and a case in which the random noise is larger than expected depending on surrounding situations. Meanwhile, "small" in Table 1 indicates that the similarity and the variance value are smaller than the threshold, and "large" indicates that the similarity and the variance value are equal to or larger than the threshold.

**Table 1**

| | Category 1 | | Category 2 | | Category 3 | |
|---|---|---|---|---|---|---|
| | Similarity | Variance Value | Similarity | Variance Value | Similarity | Variance Value |
| Random noise = expected value | Small | Small | Small | Small | Large | Large |
| Random noise < expected value | Large | Small | Small | Small | Large | Large |
| Random noise > expected value | Small | Large | Small | Large | Large | Large |

As indicated in Table 1 above, only in the category 3 among the categories 1 to 3, both of the similarity and the variance value are "large" in all of patterns of the random noise. In other words, in the third determination, it is determined that the smooth change of the differential values ΔSV is present in the differential value array data 8-1. Therefore, it is possible to detect a disturbance.

The analysis unit 4, upon detecting a disturbance, corrects the sensor value array data 7-1 so as to eliminate the smooth change of the differential values ΔSV in the differential value array data 8-1. For example, the analysis unit 4 replaces the sensor values SV of the sensor value array data 7-1 with the sensor values SV of the sensor value array data 7-2. Accordingly, the influence of the disturbance is eliminated from the sensor value array data 7-1. Meanwhile, it is not necessary to actually generate, from the corrected sensor value array data 7-1 and the (non-corrected) sensor value array data 7-2, the differential value array data 8-1 from which the smooth change of the differential values ΔSV is eliminated.

The analysis unit 4 determines occurrence or non-occurrence of localized corrosion of the pipe 50 based on the sensor value array data 7-1. The sensor value array data 7-1 in this example is the corrected sensor value array data 7-1 when the above-described correction is performed. The analysis unit 4 reads one of the plurality of pieces of sensor value array data 7 stored in the storage unit 6 as reference sensor value array data. The reference sensor value array data is the sensor value array data 7 that is acquired before occurrence of the localized corrosion of the pipe 50, and, for example, is selected in advance by a user of the detection device 100 (an administrator or the like of the pipe 50). The reference sensor value array data is the sensor value array data 7 that is not affected by the disturbance.

The analysis unit 4 calculates the differential values ΔSV between the sensor values SV of the sensor value array data 7-1 and the sensor values SV of the reference sensor value array data, and generates the differential value array data 8-2 (the second differential value array data 8). A basic data structure of the differential value array data 8-2 is the same as the differential value array data 8-1, and therefore, explanation thereof will be omitted.

The analysis unit 4 determines presence or absence of the local change of the differential values ΔSV in the differential value array data 8-2. The determination method is not specifically limited, but, for example, it may be possible to use pattern matching. If the local change of the differential values ΔSV is present in the differential value array data 8-2, the analysis unit 4 determines that the localized corrosion has occurred in the pipe 50. In other cases, the analysis unit 4 determines that localized corrosion has not occurred in the pipe 50. In this manner, it is possible to detect the local change between the sensor values SV that are acquired at different times in the plurality of sensors 1, that is, the localized corrosion of the pipe 50.

The display unit 5 displays an analysis result of the analysis unit 4. For example, information indicating occurrence or non-occurrence of the localized corrosion of the pipe 50 is displayed for the user of the detection device 100. It is possible to use the analysis result of the analysis unit 4 to determine necessity of maintenance of the pipe 50 or the like.

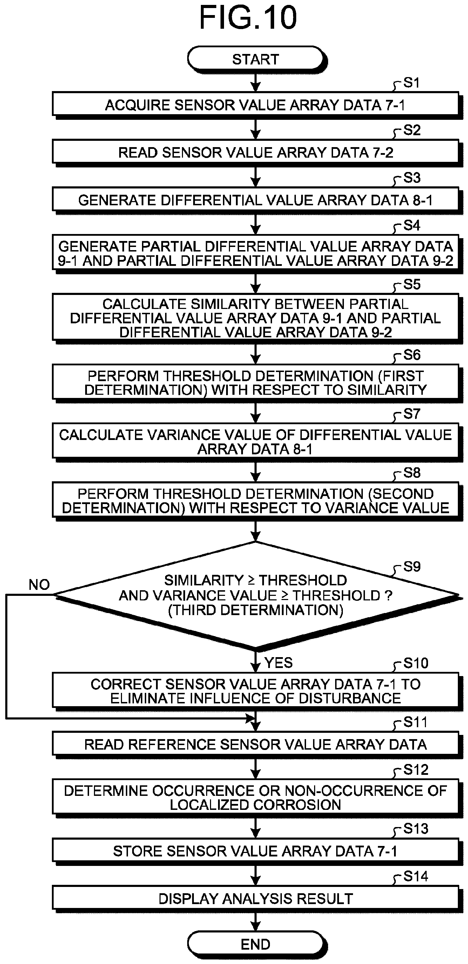

FIG. 10 is a flowchart illustrating an example of a process (a detection method or an analysis method) performed by the detection device 100. Specific processes have already been described above, and detailed explanation thereof will not be repeated.

At Step S1, the sensor value array data 7-1 is acquired. The acquisition unit 3 of the detection unit 2 acquires the sensor value array data 7-1 in which each of the sensor values SV acquired from the plurality of sensors 1 is associated with the array position of each of the sensors 1.

At Step S2, the sensor value array data 7-2 is read. The analysis unit 4 of the detection unit 2 reads the sensor value array data 7-2 that is stored in the storage unit 6.

At Step S3, the differential value array data 8-1 is generated. The analysis unit 4 of the detection unit 2 generates the differential value array data 8-1 in which the differential values ΔSV between the sensor values SV of the sensor value array data 7-1 and the sensor value array data 7-2 are associated with the array positions of the plurality of sensors 1.

At Step S4, the partial differential value array data 9-1 and the partial differential value array data 9-2 are generated. The analysis unit 4 of the detection unit 2 generates, from the differential value array data 8-1, the partial differential value array data 9-1 and the partial differential value array data 9-2, each including the same number of elements are including some overlapping elements.

At Step S5, the similarity between the differential values ΔSV of the partial differential value array data 9-1 and the partial differential value array data 9-2 is calculated. The analysis unit 4 of the detection unit 2 calculates, for example, a correlation coefficient of the differential values ΔSV of the partial differential value array data 9-1 and the partial differential value array data 9-2.

At Step S6, the threshold determination (first determination) with respect to the similarity is performed. The analysis unit 4 of the detection unit 2 determines whether the similarity as described above is equal to or larger than the threshold or smaller than the threshold.

At Step S7, the variance value of the differential value array data 8-1 is calculated. The analysis unit 4 of the detection unit 2 adopts the plurality of differential values ΔSV that are elements of the differential value array data 8-1 as a population, and calculates a variance value of the population.

At Step S8, the threshold determination (second determination) with respect to the variance value is performed. The analysis unit 4 of the detection unit 2 determines whether the variance value as described above is equal to or larger than the threshold or smaller than the threshold.

At Step S9, determination (third determination) on whether the similarity is equal to or larger than the threshold and the variance value is equal to or larger than the threshold is performed. The analysis unit 4 of the detection unit 2 determines whether the similarity is equal to or larger than the threshold in the first determination and the variance value is equal to or larger than the threshold in the second determination. If both of the similarity and the variance value are equal to or larger than the thresholds (Step S9: Yes), the analysis unit 4 determines that the smooth change of the differential values ΔSV is present in the differential value array data 8-1, that is, detects a disturbance, and the process goes to Step S10. In other cases (Step S9: No), the process goes to Step S11.

At Step S10, the sensor value array data 7-1 is corrected so as to eliminate the influence of the disturbance. For example, the analysis unit 4 of the detection unit 2 replaces the sensor values SV of the sensor value array data 7-1 with the sensor values SV of the sensor value array data 7-2.

At Step S11, the reference sensor value array data is read. The analysis unit 4 of the detection unit 2 reads one of the plurality of pieces of sensor value array data 7 stored in the storage unit 6 as the reference sensor value array data.

At Step S12, occurrence or non-occurrence of localized corrosion is determined. The analysis unit 4 of the detection unit 2 calculates the differential values ΔSV between the sensor values SV of the sensor value array data 7-1 and the sensor values SV of the reference sensor value array data, and generates the differential value array data 8-2. The sensor value array data 7-1 at this time is the corrected sensor value array data 7-1 if the correction as described above is performed. The analysis unit 4 determines presence or absence of the local change of the differential values ΔSV in the differential value array data 8-2. If the local change of the differential values ΔSV is present in the differential value array data 8-2, the analysis unit 4 determines that the localized corrosion has occurred in the pipe 50.

At Step S13, the sensor value array data 7-1 is stored. The sensor value array data 7-1 is stored and accumulated in the storage unit 6. If the process at Step S10 is performed, the sensor value array data 7-1 from which the influence of the disturbance is eliminated is stored in the storage unit 6.

At Step S14, the analysis result is displayed. The display unit 5 of the detection unit 2 displays the analysis result of the analysis unit 4.

For example, by repeatedly performing the processes as described above at a predetermined cycle, occurrence of the localized corrosion of the pipe 50 is detected. The localized corrosion of the pipe 50 is monitored. Meanwhile, the processes at Step S10 to Step S12 are arbitrarily performed.

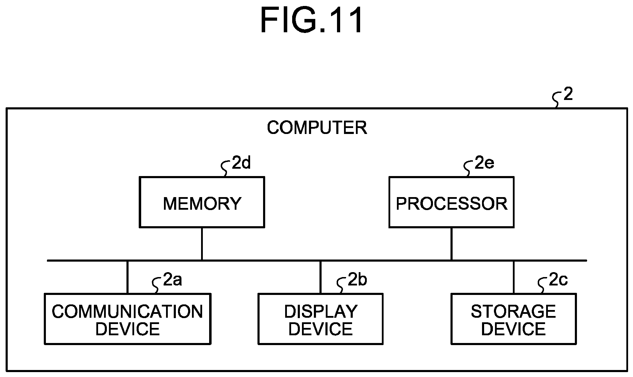

FIG. 11 is a diagram illustrating an example of a hardware configuration of the detection unit 2. A computer as illustrated by example functions as the detection unit 2 as described above. As the hardware configuration of the computer, a communication device 2a, a display device 2b, a storage device 2c, a memory 2d, and a processor 2e, all of which are connected to one another via a bus or the like, are illustrated.

The communication device 2a is a network interface card or the like and enables communication with a different device. The communication device 2a corresponds to the acquisition unit 3 of the detection unit 2. The display device 2b corresponds to the display unit 5 of the detection unit 2. The storage device 2c and the memory 2d correspond to the storage unit 6 of the detection unit 2. Examples of the storage device 2c include a hard disk drive (HDD), a read only memory (ROM), and a random access memory (RAM). The memory 2d may be a part of the storage device 2c.

The processor 2e corresponds to the analysis unit 4 of the detection unit 2. For example, the processor 2e reads (reads out) programs, such as the analysis program AP in FIG. 1, from the storage device 2c or the like and loads the programs onto the memory 2d to cause the computer to perform the processes of the analysis unit 4 of the detection unit 2.

The programs may be collectively or separately distributed via a network, such as the Internet. Furthermore, the programs may be collectively or separately stored in a non-transitory computer-readable recording medium, such as a hard disk, a flexible disk (FD), a compact disc (CD)-ROM, a magneto-optical disk (MO), or a digital versatile disc (DVD), and may be executed by being read from the recording medium by the computer.

### Modification

The disclosed technology is not limited to the embodiments as described above. Several modifications will be described below.

In the embodiments as described above, the case has been described in which the plurality of sensors 1 are arranged in a two-dimensional arrays. However, the plurality of sensors 1 may be arranged in a one-dimensional array or a three-dimensional arrays. For example, if the plurality of sensors 1 is arranged in a one-dimensional arrays(in a straight line manner), each of the array positions of the sensors 1 is identified by adopting one end as (0) and identifying an n-th position as (n). If N+1 elements are included, the partial differential value array data 9-1 includes elements in a range from (0) to (N-1). The partial differential value array data 9-2 includes elements in a range from (1) to (N). In calculation of the similarity (correlation coefficient or the like) between the differential values ΔSV of the partial differential value array data 9-1 and the partial differential value array data 9-2, it is assumed that the element (n) in the partial differential value array data 9-1 corresponds to the element (n+1) in the partial differential value array data 9-2. By the same principle as the principle as described above, it is possible to detect the smooth change between the sensor values SV that are acquired at different times in the plurality of sensors 1, that is, a disturbance. The same applies to the case in which the data is arranged in a three-dimensional array.

The sensors 1 are not limited to magnetic sensors. The sensors 1 may be interpreted as detecting means, measuring means, or the like that are able to detect various physical quantity. The sensor values SV of the sensors 1 may indicate any physical quantity.

The target object of the detection device 100 is not limited to the pipe 50. The state change of the target object detected by the detection device 100 is not limited to localized corrosion.

The disclosed technologies may be combined appropriately as long as no contradiction is derived.

### Technological Improvements

The disclosed technologies as described above are identified as described below, for example. One of the disclosed technologies is the detection device 100. As described above with reference to FIG. 1 to FIG. 10 for example, the detection device 100 includes the analysis unit 4 that detects the state change of the pipe 50 based on the sensor value array data 7-1 in which the sensor values SV that are acquired from the plurality of sensors 1 that are arranged in the pipe 50 (the target object) are associated with the array positions of the plurality of sensors 1. The analysis unit 4 generates the differential value array data 8-1 in which, with respect to the sensor value array data 7-1 and the sensor value array data 7-2 for which the sensor values SV are acquired at different times, the differential values ΔSV between the sensor value array data 7-1 and the sensor value array data 7-2 are associated with the array positions of the plurality of sensors 1, generates, from the differential value array data 8-1, the partial differential value array data 9-1 and the partial differential value array data 9-2, each including the same number of elements and including some overlapping elements, and determines presence or absence of the smooth change of the differential values ΔSV in the differential value array data 8-1 (third determination) based on a result of the threshold determination (first determination) with respect to the similarity (for example, correlation coefficient) between the differential values ΔSV of the partial differential value array data 9-1 and the partial differential value array data 9-2 and a result of the threshold determination (second determination) with respect to the variance value of the differential value array data 8-1. For example, if the similarity is equal to or larger than the threshold and the variance value is equal to or larger than the threshold, the analysis unit 4 may determine that the smooth change of the differential values ΔSV is present in the differential value array data 8-1. In this manner, it is possible to detect the smooth change between the sensor values SV of the plurality of sensors 1, for example, a disturbance.

As described above with reference to FIG. 5 for example, the partial differential value array data 9-1 (the first partial differential value array data 9) between the partial differential value array data 9-1 and the partial differential value array data 9-2 includes the elements in the first range of the differential value array data 8-1, the partial differential value array data 9-2 (the second portion the differential value array data 9) includes the elements in the second range of the differential value array data 8-1, and the second range is deviated from the first range by a predetermined number (for example, one) of elements in the array directions of the array positions of the sensors 1 associated with the differential values ΔSV of the differential value array data. For example, it is possible to detect the smooth change of the differential values ΔSV in the partial differential value array data 9-1 based on a result of the threshold determination with respect to the similarity between the differential values ΔSV of the partial differential value array data 9-1 and the partial differential value array data 9-2 that are deviated from each other by the predetermined number.

As described above with reference to FIG. 1 for example, the analysis unit 4 may correct the sensor value array data 7-1 that includes the sensor values SV for which the acquisition times are later between the sensor value array data 7-1 and the sensor value array data 7-2, and detect the state change of the pipe 50 based on the corrected sensor value array data 7-1. For example, the analysis unit 4 generates the differential value array data 8-2 (the second differential value array data 8) in which the differential values ΔSV between the sensor values SV of the corrected sensor value array data 7-1 and the reference sensor value array data (one of the sensor value array data 7) are associated with the array positions of the plurality of sensors 1, and determine presence or absence of the local change of the differential values ΔSV in the generated differential value array data 8-2. With this configuration, for example, it is possible to detect the state change of the pipe 50 while eliminating an influence of a disturbance.

As described above with reference to FIG. 1 for example, the pipe 50 is a metal pipe, the plurality of sensors 1 are a plurality of magnetic sensors, and the state change of the pipe 50 includes occurrence or non-occurrence of the localized corrosion of the pipe 50. With this configuration, it is possible to use the detection device 100 as, for example, a localized corrosion monitoring device that detects occurrence of localized corrosion of the pipe 50.

As described above with reference to FIG. 1 and FIG. 2 for example, the pipe 50 has a cylindrical shape, and the plurality of sensors 1 may be arranged in a two-dimensional array in a circumferential direction (the θ direction) and an axial direction (the z direction) of the cylindrical coordinate system. For example, it is possible to detect a smooth change between the sensor values SV of the plurality of sensors 1 that are arrayed as described above.

Meanwhile, non-exclusive features among the features as described above may be combined appropriately.

The analysis method explained above with reference to FIG. 10 for example is one of the disclosed technologies. The analysis method is a method of analyzing the sensor value array data 7-1 in which the sensor values SV acquired from the plurality of sensors 1 that are arrayed are associated with the array positions of the plurality of sensors 1. The analysis method includes generation of the differential value array data 8-1 in which, with respect to the sensor value array data 7-1 and the sensor value array data 7-2 for which the sensor values SV are acquired at different times, the differential values ΔSV of the sensor values SV of the sensor value array data 7-1 and the sensor value array data 7-2 are associated with the array positions of the plurality of sensors 1 (Step S3), generation of, from the differential value array data 8-1, the partial differential value array data 9-1 and the partial differential value array data 9-2 each including the same number of elements and including overlapping elements (Step S4), and determination on presence or absence of the smooth change of the differential values ΔSV in the differential value array data 8-1 based on a result of the threshold determination (first determination) with respect to the similarity between the differential values ΔSV of the partial differential value array data 9-1 and the partial differential value array data 9-2 and a result of the threshold determination (second determination) with respect to the variance value of the differential value array data 8-1 (third determination) (Step S6 to Step S9). With the analysis method as described above, it is possible to detect the smooth change between the sensor values SV of the plurality of sensors 1 as described above.

The analysis program AP described above with reference to FIG. 1 and FIG. 11 for example is one of the disclosed technologies. The analysis program AP causes a computer to perform a process of analyzing the sensor value array data 7-1 in which the sensor values SV acquired from the plurality of sensors 1 that are arrayed are associated with the array positions of the plurality of sensors 1. The analysis program AP causes a computer to perform a process of generating the differential value array data 8-1 in which, with respect to the sensor value array data 7-1 and the sensor value array data 7-2 for which the sensor values SV are acquired at different times, the differential values ΔSV of the sensor values SV of the sensor value array data 7-1 and the sensor value array data 7-2 are associated with the array positions of the plurality of sensors 1, generating, from the differential value array data 8-1, the partial differential value array data 9-1 and the partial differential value array data 9-2 each including the same number of elements and including overlapping elements, and determining presence or absence of the smooth change of the differential values ΔSV in the differential value array data 8-1 based on a result of the threshold determination with respect to the similarity between the differential values ΔSV of the partial differential value array data 9-1 and the partial differential value array data 9-2 and a result of the threshold determination with respect to the variance value of the differential value array data 8-1. With the analysis program AP as described above, it is possible to detect the smooth change between the sensor values SV of the plurality of sensors 1 as described above. Furthermore, a non-transitory computer-readable recording medium in which the analysis program AP is recorded is one of the disclosed technologies.

Although the disclosure has been described with respect to only a limited number of embodiments, those skilled in the art, having benefit of this disclosure, will appreciate that various other embodiments may be devised without departing from the scope of the present invention. Accordingly, the scope of the invention should be limited only by the attached claims.

## Claims

1. A detection device (100) comprising:
a processor (2e) configured to:
detect a state change of a target object (50) based on sensor value array data (7-1) in which sensor values (SV) acquired from sensors (1) are associated with array positions of the sensors (1), wherein the sensors (1) are disposed in an array manner with respect to the target object (50);
generate, with respect to two pieces of the sensor value array data (7-1, 7-2) for which the sensor values (SV) are acquired at different times, differential value array data (8-1) in which differential values (ΔSV) of the sensor values (SV) of the two pieces of the sensor value array data (7-1, 7-2) are associated with the array positions of the sensors (1);
generate, from the differential value array data (8-1), two pieces of partial differential value array data (9-1, 9-2) each of which includes same number of elements and overlapping elements; and
determine presence or absence of a smooth change of the differential values (ΔSV) in the differential value array data (8-1) based on:
a result of threshold determination on similarity between the differential values (ΔSV) in the two pieces of partial differential value array data (9-1, 9-2), and
a result of threshold determination on a variance value of the differential value array data (8-1).

2. The detection device (100) according to claim 1, wherein the processor (2e) is configured to determine that the smooth change of the differential values is present in the differential value array data when the similarity is equal to or larger than a threshold and the variance value is equal to or larger than a threshold.

3. The detection device (100) according to claim 1 or claim 2, wherein the similarity includes a correlation coefficient.

4. The detection device (100) according to any one of claims 1 to 3, wherein
first partial differential value array data (9-1) of the two pieces of partial differential value array data (9-1, 9-2) includes elements in a first range of the differential value array data (8-1),
second partial differential value array data (9-2) of the two pieces of partial differential value array data (9-1, 9-2) includes elements in a second range of the differential value array data (8-2), and
the second range is deviated from the first range by one or more elements in array directions of the array positions of the sensors (1) associated with the differential values (ΔSV) of the differential value array data (8-1).

5. The detection device (100) according to claim 4, wherein the second range is deviated from the first range by one element.

6. The detection device 100) according to any one of claims 1 to 5, wherein the processor (2e) is configured to:
correct the sensor value array data (7-1) including the sensor values (SV) for which acquisition times are later between the two pieces of the sensor value array data (7-1, 7-2); and
detect the state change of the target object (50) based on the corrected sensor value array data (7-1).

7. The detection device (100) according to claim 6, wherein the processor (2e) is configured to:
generate second differential value array data (8-2) in which differential values (ΔSV) between sensor values (SV) of the corrected sensor value array data (7-1) and reference sensor value array data (7) are associated with the array positions of the sensors (1); and
determine presence or absence of a local change of differential values (ΔSV) in the generated second differential value array data (8-2).

8. The detection device (100) according to any one of claims 1 to 7, wherein
the target object (50) is a metal target object,
the sensors are magnetic sensors, and
the state change of the target object (50) includes occurrence of localized corrosion of the target object (50).

9. The detection device (100) according to any one of claims 1 to 8, wherein
the target object (50) has a cylindrical shape, and
the sensors are disposed in a two-dimensional array in a circumferential direction (θ) and an axial direction (z) of a cylindrical coordinate system.

10. An analysis method comprising:
analyzing sensor value array data (7-1) in which sensor values (SV) acquired from sensors (1) disposed in an array manner are associated with array positions of the sensors (1);
generating, with respect to two pieces of the sensor value array data (7-1, 7-2) for which the sensor values (SV) are acquired at different times, differential value array data (8-1) in which differential values (ΔSV) of the sensor values (SV) of the two pieces of the sensor value array data (7-1, 7-2) are associated with the array positions of the sensors (1);
generating, from the differential value array data (8-1), two pieces of partial differential value array data (9-1, 9-2) each of which includes same number of elements and overlapping elements; and
determining presence or absence of a smooth change of the differential values (ΔSV) in the differential value array data (8-1) based on:
a result of threshold determination on similarity between the differential values (ΔSV) in the two pieces of partial differential value array data (9-1, 9-2), and
a result of threshold determination on a variance value of the differential value array data (8-1).

11. An analysis computer program (AP) comprising instructions which, when the program is executed by a computer, cause the computer to carry out the method of claim 10.

12. A non-transitory computer-readable recording medium storing instructions that cause a computer to carry out the method of claim 10.
